# EUROPÄISCHE PATENTANMELDUNG

(11) **EP 3 474 024 A1**
(43) Veröffentlichungstag der Anmeldung: **24.04.2019**
(21) Anmeldenummer: 17197302.7
(22) Anmeldetag: 19.10.2017
(51) Int. Cl.: G01R 15/18, H01F 38/30

(54) **STROMWANDLER MIT FLUID- ODER ÖLPAPIERISOLIERUNG FÜR HOCHSPANNUNG**

(71) Anmelder: RITZ Instrument Transformers GmbH, 22041 Hamburg (DE)
(72) Erfinder: Kipp, Herbert, 27367 Reeßum/Taaken (DE)
(74) Vertreter: Glawe, Delfs, Moll

(57) **Zusammenfassung**

Stromwandler mit Fluid- oder Ölpapierisolierung für Hochspannung, mit einem Kopfgehäuse (11), das von einem Primärleiter (3) durchquert ist. In dem Kopfgehäuse (11) ist eine von dem Primärleiter (3) durchsetzte Messeinrichtung (2) angeordnet. Erfindungsgemäß umfasst der Primärleiter (3) zwei verschiedene Arten, und zwar als erste Art einen Außenrohr-Primärleiter (30) und als zweite Art einen oder mehrere Innenleiter-Primärleiter (41, 42, 43). Der Außenrohr-Primärleiter (30) umschließt einen Innenraum (35), der zur Aufnahme der Innenleiter-Primärleiter (41, 42, 43) ausgebildet ist, und die Innenleiter-Primärleiter (41, 42, 43) sind in den Innenraum (35) einsteckbar. Die Besonderheit liegt in dem Außenrohr-Primärleiter, der einerseits zur Leistungsübertragung dient und andererseits eine Umhüllung für die Innenleiter schafft. Es braucht nur der Außenrohr-Primärleiter gegenüber dem Kopfgehäuse abgedichtet zu werden. Innenleiter können daher leicht nachträglich eingesteckt oder entfernt werden, ohne dass eine Befassung mit Dichtmaßnahmen erforderlich wäre.

## Beschreibung

Die Erfindung betrifft einen Stromwandler (Kombiwandler) mit Fluid- oder Ölpapierisolierung für Hochspannung, mit einem Kopfgehäuse, das von einem Primärleiter durchquert ist, wobei in dem Kopfgehäuse eine von dem Primärleiter durchsetzte Messeinrichtung mit einem in einer Schutzhülle angeordneten Messkern angeordnet ist.

Für den Betrieb von Energieübertragungsnetzen besteht vielfach im Hochspannungssystem ein Bedarf, Ströme zu messen. Dies gilt für verschiedene Anwendungen, insbesondere für den Betrieb des Netzes an sich, für Verbraucheranschlüsse oder auch für Anschlüsse von Erzeugern. Wegen dieser unterschiedlichen Anwendungsfälle wird daher eine hohe Skalierbarkeit bezüglich des Strommessbereichs von den Strommesseinrichtungen (Stromwandler) erwartet.

Seit langem bekannt sind Stromwandler für Hochspannungssysteme mit kontaktloser Messung. Hierbei ist ein den Strom auf Hochspannungsniveau führender Primärleiter mittig durch eine torusförmige Messeinrichtung geführt. Zur Erweiterung des Strommessbereichs kann der Primärleiter mehrsträngig ausgeführt werden, häufig mit vier parallelen Strängen. Hierbei sind die Stränge mechanisch parallel durch die torusförmige Messeinrichtung geführt. Elektrisch können die Stränge wahlweise in Reihenschaltung (mit externer Rückführung) oder Parallelschaltung verbunden werden. Indem die Stränge in Reihe geschaltet werden, kann der Strommessbereich nach unten, und durch Parallelschaltung der Strommessbereich nach oben erweitert werden.

Generell sind zur Vermeidung von Überschlägen Hochspannungswandler meist mittels Fluid - und/oder Ölpapierisolierung isoliert. Bei einer mehrsträngigen Ausführung des Primärleiters führt dies zu dem Nachteil, dass eine mehrfache Durchführung durch den mittels Fluid - und/oder Ölpapierisolierung isolierten Innenraum erforderlich ist. Dies bedingt eine Vielzahl von Dichtungen. Meist müssen pro Strang zwei Dichtungen (am Eintritt sowie am Austritt) vorgesehen werden. Dies ist aufwendig und kann meist nur im Werk bei der Herstellung erfolgen. Eine nachträgliche Anpassung an einen veränderten Strommessbereich durch Hinzufügen weiterer Stränge ist deswegen kaum praktikabel.

Der Erfindung liegt daher die Aufgabe zugrunde, Stromwandler für Hochspannungssysteme dahingehend zu verbessern, dass sie mit weniger Aufwand besser anpassbar sind.

Die erfindungsgemäße Lösung liegt in den Merkmalen des unabhängigen Anspruchs. Vorteilhafte Weiterbildungen sind Gegenstand der abhängigen Ansprüche.

Bei einem Stromwandler mit Fluid- oder Ölpapierisolierung für Hochspannung, mit einem Kopfgehäuse, das von einem Primärleiter durchquert ist, wobei in dem Kopfgehäuse eine von dem Primärleiter durchsetzte Messeinrichtung angeordnet ist, ist erfindungsgemäß vorgesehen, dass der Primärleiter zwei verschiedene Arten umfasst, und zwar als erste Art einen Außenrohr-Primärleiter und als zweite Art einen oder mehrere Innenleiter-Primärleiter, wobei der Außenrohr-Primärleiter einen Innenraum umschließt, der zur Aufnahme der Innenleiter-Primärleiter ausgebildet ist, und die Innenleiter-Primärleiter in den Innenraum einsteckbar sind.

Kern der Erfindung ist der Gedanke, mit dem Außenrohr einen besonderen Primärleiter zu schaffen, der einerseits zur Leistungsübertragung dient und andererseits eine Umhüllung für die Innenleiter schafft. Die Erfindung hat erkannt, dass somit nur der Außenrohr-Primärleiter gegenüber dem Kopfgehäuse abgedichtet werden muss, und daher Innenleiter problemlos nachträglich eingesteckt oder entfernt werden können, ohne dass eine Befassung mit Dichtmaßnahmen erforderlich wäre. Es wird erfindungsgemäß somit eine besondere Kombination geschaffen, bei der das als schützende Umhüllung fungierende Außenrohr zugleich Primärleiter ist.

Eine nachträgliche Änderung hinsichtlich der Konfiguration und Anzahl der Primärleiter ist damit auf einfache Weise möglich. Ferner wird die Anzahl der Dichtungen verringert auf zwei (je eine am Anfang und Ende des Außenrohr-Primärleiters) gegenüber zwei je Strang (das waren insgesamt acht Dichtungen bei der häufigen Ausführung mit vier Leitersträngen), was nicht nur eine Verringerung des Herstellungsaufwands bedeutet, sondern auch eine Erhöhung der Zuverlässigkeit mit sich bringt.

Außerdem hat die Erfindung den Vorteil, dass die Innenleiter keinen unmittelbaren Kontakt zu dem Kopfgehäuse haben und damit thermisch besser isoliert sind, wodurch die - an sich unerwünschte - Erwärmung des Stromwandlers und insbesondere seiner Messeinrichtung wegen unvermeidlicher Stromwärmeverluste in den Primärleitern minimiert wird.

Unter einem Fluid wird Gas, beispielsweise Schwefelhexafluorid SF6, oder Flüssigkeit, beispielsweise Öl, verstanden.

Zweckmäßigerweise sind in dem Innenraum mehrere Aufnahmetaschen gebildet, welche den oder die Innenleiter-Primärleiter im Innenraum positionieren. Damit ist die Positionierung der Innenleiter-Primärleiter definiert, so dass sie bei Bedarf einfach in die Aufnahmetasche eingeschoben werden können. Weitergehende Maßnahmen für eine korrekte Aufnahme oder Positionierung der Innenleiter-Primärleiter sind nicht erforderlich. Vorzugsweise sind für die Aufnahmetaschen Abstandshalter vorgesehen. Damit ergibt sich automatisch durch das Einschieben der Innenleiter-Primärleiter auch deren korrekte Positionierung. Besonders zweckmäßig ist es, wenn die Abstandshalter in die Aufnahmetasche integriert sind, so dass keine zusätzlichen Bauteile benötigt werden. Eine Nachrüstung des erfindungsgemäßen Stromwandlers mit weiteren Innenleiter-Primärleitern ist damit deutlich vereinfacht. Vorzugsweise sind die Innenleiter-Primärleiter luftisoliert ausgeführt.

Vorzugsweise sind die Innenleiter-Primärleiter in Umfangsrichtung gleichmäßig verteilt angeordnet. Dies bietet einen maximalen Abstand zwischen den einzelnen Primärleitern, was gerade im Fall der Reihenschaltung günstig ist für auftretenden Potenzialunterschiede zwischen den Innenleiter-Primärleitern. Ferner ergeben sich günstige Verläufe für die Feldlinien der elektrischen und magnetischen Felder. Besonders zweckmäßig ist eine Anordnung von drei Innenleiter-Primärleiter an Eckpunkten eines Dreiecks, das insbesondere rechtwinklig und gleichschenklig ist.

Der Außenrohr-Primärleiter ist vorzugsweise nur auf einer Seite isoliert in das Kopfgehäuse geführt und aus der gegenüberliegenden Seite über eine Kontaktgrundplatte leitend mit dem Kopfgehäuse verschraubt. Ferner ist es zweckmäßig, wenn der oder die Innenleiter-Primärleiter isoliert sind gegenüber dem Außenrohr-Primärleiter. Damit ist es möglich, dass Potenzialunterschiede zwischen Innenleiter und Außenrohr bestehen können. Das kann insbesondere für eine Reihenschaltung der Innenleiter genutzt werden, umso den Strommessbereich zu erweitern.

Bei einer bewährten Ausführungsform ist der Innenraum einheitlich und frei von Zwischenwänden ausgeführt. Somit besteht eine größtmögliche Variabilität bei der Nutzung des Innenraums mit verschiedenen Innenleiter-Primärleitern.

Mit Vorteil ist der Außenrohr-Primärleiter so ausgeführt, dass er eine in den Innenraum weisende Ausstülpung aufweist. Diese Ausstülpung engt den Innenraum an einer Stelle ein. Vorzugsweise ist es genau die Stelle, an der ein (fiktiver) zusätzlicher Innenleiter angeordnet wäre (innenleitergleiche Positionierung der Ausstülpung). Mit dieser Ausstülpung wird zum einen ein gut leitender Bereich mit großem Querschnitt für den Außenrohr-Primärleiter bereitgestellt, zum anderen wird damit eine flächenmäßig große Anschraubfläche an den Enden des Außenrohr-Primärleiters geschaffen. Sie stellt damit eine querschnittsmäßig gesehen große und somit niederohmige sowie sichere Anschlussmöglichkeit für den Strom zuführende bzw. abführende Hochspannungsleitungen dar. Zur Anordnung der zuführenden bzw. abführenden Hochspannungsleitungen sind vorzugsweise an beiden Enden des Außenrohr-Primärleiters entsprechende Anschlüsse vorgesehen. Zweckmäßigerweise ist der Querschnitt der Ausstülpung mindestens so groß gewählt wie derjenige eines der Innenleiter-Primärleiters. Damit ist sichergestellt, dass über die Ausstülpung der Strom genauso gut und mit gleichen (oder sogar geringeren) Verlusten geführt werden kann wie über die Innenleiter-Primärleiter.

Die Erfindung wird nachfolgend unter Bezugnahme auf die beigefügte Zeichnung anhand eines Ausführungsbeispiels näher erläutert. Es zeigen:
- Fig. 1: eine Ansicht eines Stromwandlers mit Isolatorfuß und Kopfgehäuse;
- Fig. 2: eine schematische Ansicht der Anordnung der Innenleiter im Außenrohr-Primärleiter (mit Stromdichte);
- Fig. 3a-c: Frontansichten des Kopfgehäuses ohne und mit Innenleitern;
- Fig. 4a-c: Frontansichten mit montierten Innenleitern und deren Anschlüssen; und
- Fig. 5: eine schematische Längsschnittdarstellung des Kopfgehäuses eines zweiten Ausführungsbeispiels.

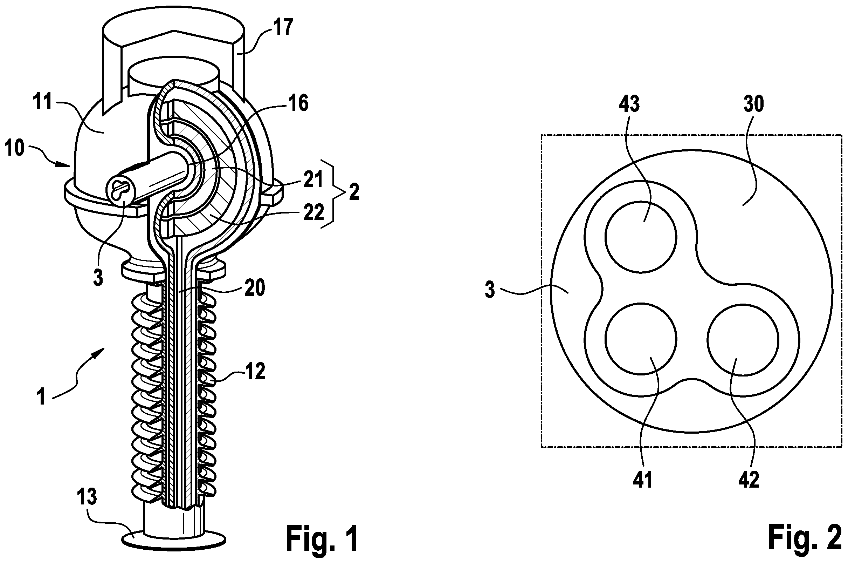

Ein in seiner Gesamtheit mit der Bezugsziffer 1 bezeichneter Stromwandler für Hochspannungsanwendungen ist in einer teilgeschnittenen Darstellung in Figur 1 dargestellt. Der Stromwandler 1 weist einen Wandlerkopf 10 mit einem Gehäuse 11 auf, der am oberen Ende eines langgestreckten Isolatorfußes 12 angeordnet ist. Oben auf dem Wandlerkopf 10 ist ein Topf 17 angeordnet.

Mit einem Flansch 13 am unteren Ende des Isolatorfußes 12 ist der Stromwandler 1 fest auf einer Unterlage montierbar. In dem Inneren des Isolatorfußes 12 ist ein Sekundärleiter 20 angeordnet, der die von einem Messkern 2 im Wandlerkopf 10 aufgenommene Signale für einen gemessenen Strom zu einem Anschlusskasten 14 am Flansch 13 führt.

Der Wandlerkopf 10 weist eine scheibenartige Gestalt mit einer mittigen Durchgangsöffnung 16 auf. Durch die Durchgangsöffnung 16 ist ein Primärleiter 3 geführt.

Um die Durchgangsöffnung 16 herum ist eine torusförmige Messeinrichtung 2 in dem Wandlerkopf 10 angeordnet. Sie ist zweilagig ausgeführt und weist zwei Messkerne 21, 22 auf, die konzentrisch um die Durchgangsöffnung 16 angeordnet sind. Die Messkerne sind - in an sich bekannter Weise - dazu ausgebildet, den durch den Primärleiter 3 geführten Strom berührungslos zu erfassen und ein entsprechendes Signal über den im Isolatorfuß 12 angeordneten Signalleiter 20 auszugeben.

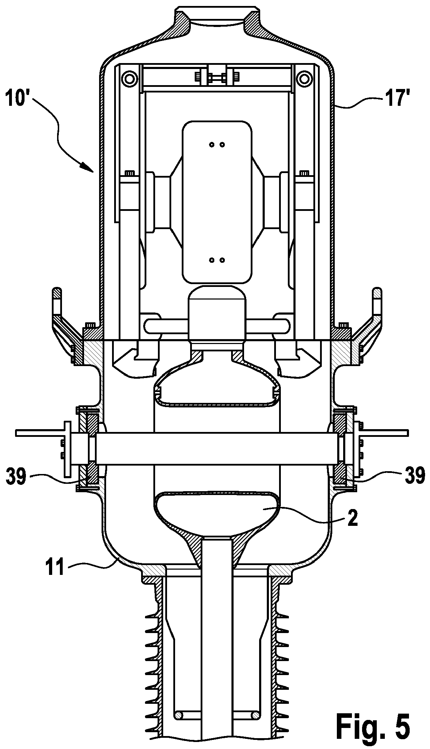

Bei dem in Figur 1 dargestellten Stromwandler handelt es sich um einen öl-isolierten Stromwandler. Die Erfindung kann ebenso ausgeführt sein an einem mittels Schutzgas isolierten Stromwandler. Dies ist in Fig. 5 schematisch dargestellt. Bei dieser alternativen Ausführungsform ist der Wandlerkopf 10' mit einer Gasisolierung anstelle der Ölisolierung versehen. Man erkennt, dass hierbei der Topf 17' eine größere Bauhöhe aufweist. Aus Übersichtsgründen sind in Fig. 5 wie auch in Fig. 1 Anschlussplatten für den Primärleiter nicht dargestellt.

Der Primärleiter 3 besteht aus einem Außenrohr-Primärleiter 30 mit einem Innenraum 35, in dem einer oder mehrere Innenleiter-Primärleiter 41, 42, 43 aufnehmbar sind.

Unabhängig von der Art des isolierenden Mediums muss der Primärleiter 3 abgedichtet sein. Zu diesem Zweck sind an den Stellen, an denen der Außenrohr-Primärleiter 30 in den Wandlerkopf 10 eintritt bzw. austritt jeweils eine Dichtung 39 vorgesehen. Die Dichtung 39 umgibt jeweils den Primärleiter 30 an seinem Außenumfang.

Die Anordnung von Innenleiter-Primärleiter relativ zu dem Außenrohr Primärleiter ist in Figur 2 dargestellt. Man erkennt den Außenrohr-Primärleiter 30, in dem ein Innenraum gebildet ist. Der Innenraum ist vorgesehen zur Aufnahme von drei Innenleiter-Primärleiter 41, 42, 43. Sie sind als kreisförmige Stäbe ausgeführt und in verrundeten Aufnahmetaschen 31, 32, 33 des Innenraums angeordnet. Hierbei ist die Form der Aufnahmetaschen 31, 32, 33 so auf die Innenleiter-Primärleiter 41, 42, 43 abgestimmt, dass sich im wesentlichen gleichmäßige Abstände zwischen dem Außenumfang der Innenleiter-Primärleiter 41, 42, 43 einerseits und dem Rand des Innenraums 35 andererseits ergeben, wobei die Abstände zwischen zwei benachbarten Innenleiter-Primärleitern 41, 42 bzw. 41, 43 jeweils doppelt so groß sind wie der Abstand zwischen Innenleiter-Primärleiter 41, 42, 43 und dem Rand des Innenraums 35. Damit wird eine gleichmäßige Feldverteilung des elektromagnetischen Feldes erreicht. Die Innenleiter-Primärleiter sind luftisoliert gegenüber dem sie umgebenden Außenrohr-Primärleiter 30.

Erfindungsgemäß ist der Innenraum 35 zur Umgebung hin offen. Damit können die Innenleiter-Primärleiter 41, 42, 43 dichtungsfrei in den Innenraum 35 des Außenrohr-Primärleiters 30 eingesetzt sein. Eine Nachrüstung mit Innenleiter-Primärleiter 41, 42, 43 ist damit leicht und auch im Feld möglich. Die einzigen Dichtungen sind außenseitig an dem Außenrohr-Primärleiter 30 vorgesehen, und werden bereits im Werk eingesetzt. Damit ergibt sich eine robuste und gut nachrüstbare Gesamtkonstruktion.

Die drei Innenleiter-Primärleiter 41, 42, 43 sind angeordnet in einer Dreieckskonfiguration und zwar in der Weise, dass sie Eckpunkte eines rechtwinkligen gleichschenkeligen Dreiecks bilden. Bezogen auf den Querschnitt des Außenrohr-Primärleiters 30 ist das von den drei Innenleiter-Primärleiter 41, 42, 43 gebildete Dreieck außermittig angeordnet. Es verbleibt somit ein Raum für eine Ausstülpung 34 des Außenrohr-Primärleiters 30. Dieser ist an der Stelle angeordnet, an der - bei regelmäßiger Anordnung - ein vierter Innenleiter angeordnet wäre. Die Ausstülpung 34 ist so beschaffen, dass ihr Querschnitt mindestens so groß ist wie einer der Innenleiter-Primärleiter 41, 42, 43. Damit tritt das von ihr hervorgerufene elektrische Feld funktionell an die Stelle eines weiteren Innenleiters. Im Ergebnis ergibt sich damit nicht nur eine günstige Feldverteilung, sondern auch eine günstige Stromdichteverteilung. Diese ist in Figur 2 durch unterschiedliche Stufen von Grauschattierung kenntlich gemacht.

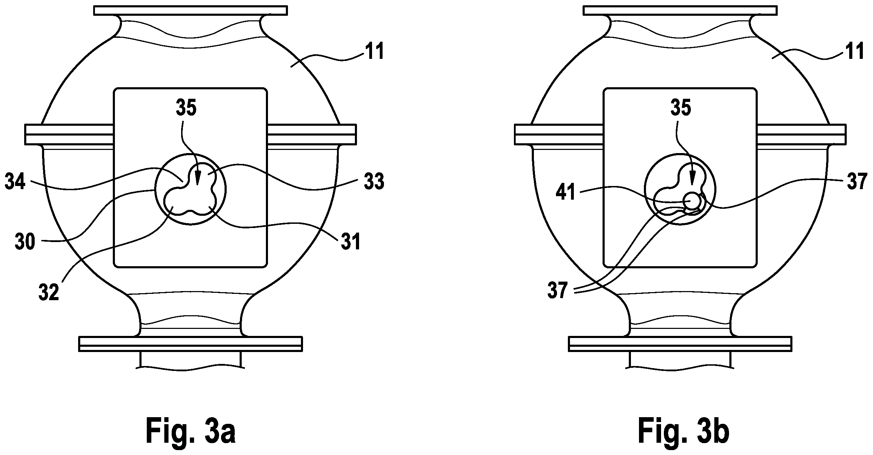

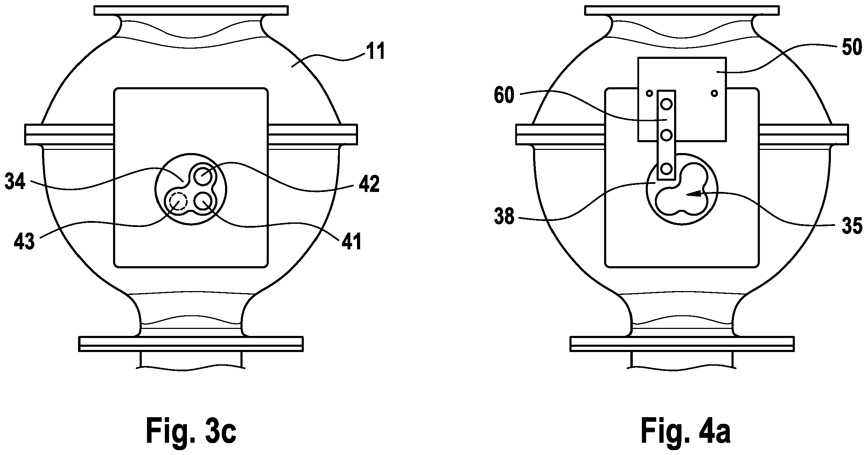

Verschiedene Anordnungsvarianten von Innenleiter-Primärleiter in dem gemeinsamen Außenrohr-Primärleiter 30 sind in den Figuren 3 bis 5 dargestellt. Sie zeigen jeweils eine Teilansicht auf den Wandlerkopf, und zwar von der Achse des Außenrohr-Primärleiters 30 gesehen. Dieser weist, wie bereits vorstehend erläutert, einen Innenraum 35 mit drei taschenartigen Ausnehmungen 31, 32, 33 (Aufnahmetaschen) zur Aufnahme von Innenleiter-Primärleiter auf. In Figur 3a ist kein Innenleiter-Primärleiter eingesteckt. Damit bildet der gesamte Innenraum 35 einen Freiraum. Im Unterschied dazu ist bei der Darstellung gemäß Figur 3b ein Innenleiter-Primärleiter 41 in den Freiraum 35 in eine mittlere der Aufnahmetaschen 31 eingesteckt. Er ist in dem dargestellten Ausführungsbeispiel durch mehrere Abstandshalter 37 in dem Innenraum 35 positionsmäßig fixiert. Die Abstandhalter 37 können als Einzelelemente ausgeführt sein oder als hülsenartige Elemente. Sie sind zweckmäßigerweise nicht entlang der gesamten Länge des Innenleiter-Primärleiters 41 angeordnet, sondern vorzugsweise nur im Bereich von dessen beiden Enden. Figur 3c zeigt eine Darstellung, bei der zwei Innenleiter Primärleiter 41, 42 eingesteckt sind. Aus Gründen der Übersichtlichkeit sind keine Abstandhalter eingezeichnet. Man erkennt, dass der Innenleiter-Primärleiter 42 in einer der beiden übrigen taschenartigen Ausnehmungen des Innenraums 35 angeordnet ist. Ein optional evtl. vorhandener dritter Innenleiter-Primärleiter 43 ist gestrichelt dargestellt.

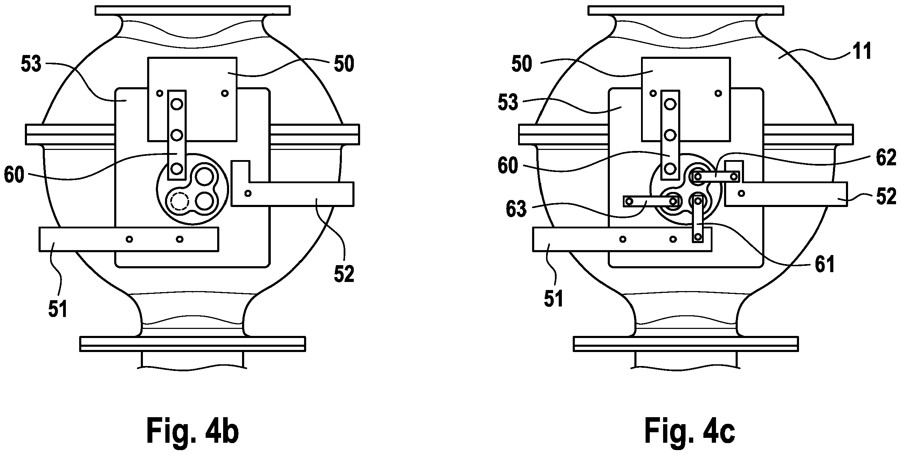

Beispiele für eine Beschaltung des Außenrohr-Primärleiters 30 bzw. der darin angeordneten Innenleiter-Primärleiter 41, 42, 43 sind in den Figuren 4a) bis c) dargestellt. In Figur 4a) ist der Grundfall dargestellt wie in Figur 3a, wonach lediglich der Außenrohr-Primärleiter 30 vorhanden ist. Für diesen ist eine Anschlussplatte 50 vorgesehen, die isoliert an einer Frontseite des Wandlerkopfs 10 angeordnet ist. Die Anschlussplatte 50 kontaktiert den Außenrohr-Primärleiter 30 über eine Anschlussschiene 60. Diese ist mittels Schraubverbindungen einerseits mit der Anschlussplatte 50 und andererseits mit dem Außenrohr-Primärleiter 30 verbunden. Zu diesem Zweck ist an dem Außenrohr-Primärleiter 30 im Bereich der Ausstülpung 34 eine Anschraubfläche 38 zur Aufnahme der Verschraubung der Anschlussschiene 60 ausgebildet. Damit kann eine betriebssichere und hochstromfeste Anschaltung des Außenrohr-Primärleiters 30 erreicht werden. Auf der Rückseite ist eine entsprechende spiegelbildliche Anordnung vorgesehen.

Dabei erfolgt die Beschaltung des Außenrohres mit Vorteil in der Weise, dass das Außenrohr 30 über die Anschlussschiene 60 mit der Anschlussplatte 50 verbunden ist. Das Außenrohr 30 ist dann der erste Leiter. Dieser wird auf der Eingangsseite isoliert in das Gehäuse 11 eingeführt und auf der gegenüberliegenden Seite über die Kontaktgrundplatte 53 leitend mit dem Gehäuse verschraubt. Das Gehäuse 11 ist dann der erste Rückleiter. Weitere Rückleiter, Kontaktierungsbügel 51 und 52 sowie zugeordnete Anschlussplatten sind isoliert auf der Kontaktgrundplatte montiert. Sie können je nach der gewünschten Schaltungsvariante über die Anschlussschienen 61, 62, 63 verschaltet werden.

Reicht die Anordnung gemäß Figur 4a) für die Übertragung der Ströme nicht aus, so können erfindungsgemäß weitere Primärleiter eingesetzt sein, und zwar als Innenleiter-Primärleiter 41, 42, 43, die in den Innenraum 35 des Außenrohr-Primärleiters 30 eingesetzt werden können. Diese sind in den Figuren 4b) und c) dargestellt. Man erkennt neben den drei Innenleiter-Primärleiter 41, 42, 43 zusätzlich noch eine Kontaktgrundplatte 53 sowie Kontaktierungsbügel 51, 52. Letztere sind so ausgebildet, dass sie außenseitig um den Wandlerkopf 10 umlaufen, um so dessen Vorder- und Rückseite miteinander zu verbinden. Die Kontaktierungsbügel 51, 52 werden einzeln mittels entsprechend zugeordneter Anschlussschienen 61, 62, 63 mit jeweils einem der Innenleiter-Primärleiter 41, 42, 43 verbunden. Damit kann eine Reihenschaltung der Innenleiter-Primärleiter 41, 42, 43 unter Einbeziehung des Außenrohr-Primärleiters 30 erreicht werden. Auf diese Weise wird der Messbereich zu kleineren Strömen hin erweitert (genauer gesagt vervierfacht).

Eine schematische Schnittdarstellung ist in Figur 5 abgebildet. Es handelt sich hierbei, wie bereits erwähnt, um eine Ausführungsform mit einem schutzgasisolierten Wandlerkopf 7. Deutlich zu erkennen ist der Außenrohr-Primärleiter 30 mit seinen Dichtungen 39, der durch eine Mittelöffnung der torusförmigen Messeinrichtung 2 geführt ist. Der Innenraum des Wandlerkopfs 10' mit der torusförmigen Messeinrichtung 2 ist durch Ölpapier oder Gas-, insbesondere Schwefelhexaflourid SF6, isoliert. Innenleiter-Primärleiter sind in dieser Abbildung nicht vorhanden; bei Bedarf können sie in den Innenraum des Außenrohr-Primärleiters 30 eingesteckt werden, ohne dass es dazu erfindungsgemäß zusätzlicher Dichtungen bedarf, da deren Abdichtung zentral von dem Außenrohr-Primärleiter 30 übernommen wird.

## Patentansprüche

1. Stromwandler mit Fluid- oder Ölpapierisolierung für Hochspannung, mit einem Kopfgehäuse (11), das von einem Primärleiter (3) durchquert ist, wobei in dem Kopfgehäuse (11) eine von dem Primärleiter (3) durchsetzte Messeinrichtung (2) angeordnet ist,
**dadurch gekennzeichnet, dass**
der Primärleiter (3) zwei verschiedene Arten umfasst, und zwar als erste Art einen Außenrohr-Primärleiter (30) und als zweite Art einen oder mehrere Innenleiter-Primärleiter (41, 42, 43), wobei der Außenrohr-Primärleiter (30) einen Innenraum (35) umschließt, der zur Aufnahme der Innenleiter-Primärleiter (41, 42, 43) ausgebildet ist, und die Innenleiter-Primärleiter (41, 42, 43) in den Innenraum (35) einsteckbar sind.

2. Stromwandler nach Anspruch 1, **dadurch gekennzeichnet, dass** in dem Innenraum (35) mehrere Aufnahmetaschen (31, 32 ,33) gebildet sind, welche den oder die Innenleiter-Primärleiter (41, 42, 43) im Innenraum (35) positionieren.

3. Stromwandler nach Anspruch 2, **dadurch gekennzeichnet, dass** für die Aufnahmetaschen (31, 32, 33) Abstandshalter (37) vorgesehen sind, vorzugsweise in integrierter Ausführung.

4. Stromwandler nach einem der vorangehenden Ansprüche,
**dadurch gekennzeichnet, dass** die Innenleiter-Primärleiter (41, 42, 43) in Umfangsrichtung gleichmäßig verteilt angeordnet sind.

5. Stromwandler nach Anspruch 4, **dadurch gekennzeichnet, dass** drei Innenleiter-Primärleiter (41, 42, 43) an Eckpunkten eines rechtwinkligen gleichschenkeligen Dreiecks angeordnet sind.

6. Stromwandler nach einem der vorangehenden Ansprüche,
**dadurch gekennzeichnet, dass** der Außenrohr-Primärleiter (30) nur einseitig isoliert ist gegenüber dem Gehäuse, vorzugsweise an der anderen Seite leitend mit dem Gehäuse verbunden ist.

7. Stromwandler nach einem der vorangehenden Ansprüche,
**dadurch gekennzeichnet, dass** der oder die Innenleiter-Primärleiter (41, 42, 43) isoliert sind gegenüber dem Außenrohr-Primärleiter (30).

8. Stromwandler nach einem der vorangehenden Ansprüche,
**dadurch gekennzeichnet, dass** der oder die Innenleiter-Primärleiter (41, 42, 43) dichtungsfrei in den Innenraum (35) montiert sind.

9. Stromwandler nach einem der vorangehenden Ansprüche,
**dadurch gekennzeichnet, dass** der Außenrohr-Primärleiter (30) eine in den Innenraum (35) weisende Ausstülpung (34) aufweist.

10. Stromwandler nach Anspruch 9, **dadurch gekennzeichnet, dass** die Ausstülpung (34) einen Querschnitt aufweist, der mindestens so groß wie derjenige der Innenleiter-Primärleiter ist (41, 42, 43).

11. Stromwandler nach Anspruch 9 oder 10, **dadurch gekennzeichnet, dass** die Ausstülpung (34) innenleitergleich positioniert ist.

12. Stromwandler nach einem der vorangehenden Ansprüche,
**dadurch gekennzeichnet, dass** am Außenrohr-Primärleiter (30) an beiden Enden Anschlüsse für Hochspannungsleiter vorgesehen sind.

13. Stromwandler nach Anspruch 12, **dadurch gekennzeichnet, dass** die Anschlüsse als Anschraubflächen (38) vorzugsweise an der Ausstülpung (34) ausgebildet sind.

14. Stromwandler nach einem der vorangehenden Ansprüche,
**dadurch gekennzeichnet, dass** die Innenleiter-Primärleiter (41, 42, 43) luftisoliert sind.
